# EUROPÄISCHE PATENTSCHRIFT

(11) **EP 3 669 312 B1**
(45) Veröffentlichungstag und Bekanntmachung des Hinweises auf die Patenterteilung: **15.03.2023**
(21) Anmeldenummer: 18786259.4
(22) Anmeldetag: 08.10.2018
(51) Int. Cl.: G06Q 10/08

(54) **VORRICHTUNG ZUM STEUERN, ÜBERWACHEN UND VISUALISIEREN VON BAUSTELLEN MIT MAGNETISCHEN SIGNALGEBER UND SCHLEIFENANTENNE.**
DEVICE FOR CONTROLLING, MONITORING AND VISUALIZING CONSTRUCTION SITES
PROCÉDÉ DE COMMANDE, DE SURVEILLANCE ET DE VISUALISATION DE CHANTIERS

(30) Priorität: 09.10.2017 DE 102017123391
(43) Veröffentlichungstag der Anmeldung: 24.06.2020
(73) Patentinhaber: Liebherr-Werk Biberach GmbH, 88400 Biberach an der Riß (DE)
(72) Erfinder: BRAMBERGER, Robert, 82293 Mittelstetten/Vogach (DE); KÖGL, Martin, 88400 Biberach an der Riss (DE)
(74) Vertreter: Thoma, Michael
(86) Internationale Anmeldenummer: PCT/EP2018/077339
(87) Internationale Veröffentlichungsnummer: WO 2019/072770

(56) Entgegenhaltungen:
- WO-A1-2008/134443
- DE-U1-202008 011 345
- US-A1- 2009 022 138
- Visible Assets Inc.: "Home", Bunker Hill Ave. 195, Stratham NH 03885, 28. September 2017 (2017-09-28), Seiten 1-7, XP055539814, Stratham, NH 03885 Gefunden im Internet: URL:http://web.archive.org/web/20170928070 918/http://www.ru-bee.com/ [gefunden am 2019-01-09]

## Beschreibung

Die vorliegende Erfindung betrifft eine Vorrichtung zum Steuern und/oder Überwachen und/oder Visualisieren von Baustellen, mit einer Erfassungseinrichtung zum Erfassen der Position eines Baumittels auf der Baustelle, wobei die Erfassungseinrichtung einen am Baumittel anbringbaren Signalgeber zum Bereitstellen eines das Baumittel identifizierenden Identifikationssignals sowie eine Signalauswerteeinrichtung zum Empfangen und Auswerten des Identifikationssignals zum Bestimmen der Position des Baumittels auf der Baustelle aufweist.

Um das Erstellen von Bauwerken wie Häuser, Brücken, Bahnhöfe oder Tiefbauwerke effizient steuern, planen und überwachen zu können, ist es hilfreich, das Vorhandensein und die Position der benötigten Baumittel auf der Baustelle automatisiert zu erfassen bzw. zu bestimmen und einem Baustellenleitrechner und/oder einem BIM-Server (Bauwerkinformationsmodell) als Daten bereitzustellen. Als Baumittel, deren Vorhandensein und Position auf der Baustelle erfasst wird, kommen dabei einerseits die benötigten Baumaschinen wie Krane, Bagger, Bohrgeräte, insbesondere aber auch am Bauwerk zu verbauende Baumaterialien wie Fassadenelemente, Betonteile wie Fertigbetontreppen, Gauben, Dachsparren, Fertigwandteile oder Dämmplatten und dergleichen, sowie Baustoffe wie Sand, Kies, Ziegelsteine, Bretter und dergleichen sowie Bauhilfswerkzeuge wie Schalungselemente, Stützträger oder Gerüstteile in Betracht.

Um solche Baumittel zu lokalisieren und zu identifizieren, ist es bekannt, GPS-Sender bzw. -systeme einzusetzen, die an jeweilige Baumittel angebracht werden, wobei aufgrund des Preises und der Empfindlichkeit solche GPS-Systeme im Wesentlichen nur für die Lokalisierung großer, teurer Baumaschinen wie Krane oder Raupen, nicht jedoch oder eher weniger für kleinteiligere Baumittel, die am Bauwerk selbst verbaut werden, eingesetzt werden. Insbesondere bei am Bauwerk zu verbauenden Baumitteln würde sich die Problematik stellen, die GPS-Sender aufgrund des Preises wieder zu entfernen. Beispielsweise zeigt die Schrift WO 2013/006625 A2 den Einsatz eines GPS-System für die Erfassung von 3D-Geodaten für Mobil- bzw. Obendreherkrane.

Unabhängig hiervon ist der Einsatz von GPS-Systemen zur Lokalisierung von Baumitteln auf einer Baustelle mit diversen Nachteilen behaftet. Neben typischen GPS-Unzulänglichkeiten bei der Positionsgenauigkeit, die durch Satellitenfehler beispielsweise in Form sich ändernder Umlaufbahnen, atmosphärische Fehler beispielsweise in Form von Schwankungen der Ausbreitungsgeschwindigkeit der Radiowellen infolge atmosphärischer Schwankungen, oder Beeinflussung durch die Satellitengeometrie beispielsweise in Form von einer engstehenden Satellitenanordnung bedingt sein können, sind vor allen Dingen Signalreflexionen und - abschirmungen verantwortlich für fehlerhafte Positionsbestimmungen. Die von GPS-Systemen verwendeten Funkwellen breiten sich regelmäßig nur geradlinig aus. Treffen sie auf leitfähige oder mineralische Hindernisse, werden sie reflektiert, sodass sich am Empfänger eintreffende Funkwellen überlagern können. Neben einer möglichen gegenseitigen Auslöschung können auch längere Laufzeiten in Folge der Reflexion auftreten, die die Positionsbestimmung erschweren. Zudem treten bei massiven Wandungen oder Metallplatten Abschirmungen auf, die es beispielsweise unmöglich machen, die Position eines GPS-Moduls zu bestimmen, das sich an einem Baumittel unter einem Stapel von Metallplatten oder im Kellergeschoss des schon teilweise errichteten Bauwerks oder in einer ähnlich abgeschirmten Position befindet.

Weiterhin wurde auch schon vorgeschlagen, RFID-Transponder zur Lokalisierung und Identifizierung von Baumitteln auf Baustellen einzusetzen. Beispielsweise beschreibt die Schrift DE 10 2004 055 033 ein System zur Verfolgung von Objekten auf Baustellen, bei dem die Objekte jeweils mit einem RFID-Transponder versehen werden, der jeweils mit einem GPS-Modul gekoppelt ist, um bei entsprechender Abfrage die aktuelle Position des Objekts zurückzumelden. Die Schriften US 2016/0034608 A1 oder DE 10 2016 203 076 A1 zeigen ähnliche RFID-Systeme zur Lokalisierung von Baustellenkomponenten bzw. Bauobjekten. Die WO 2008/134443 A1 zeigt ein System zur Nachverfolgung von Feuerwaffen mithilfe eines an der Feuerwaffe befestigten, magnetisch arbeitenden Tags, gemäß dem Oberbegriff des Anspruchs 1.

Solche RFID-System sind zwar vom Preis her sehr attraktiv, sodass sie auch bei billigeren Baumitteln wie Dämmplatten oder Armierungseisen vom Preis her theoretisch einsetzbar wären. RFID-Transponder sind jedoch sehr anfällig, was die Kommunikationsverbindung zur Auswerteeinrichtung anbelangt. Durch beispielsweise Metallkörper oder Wasserflächen treten Signalreflexionen auf, die eine Signalerfassung oft gänzlich unterbinden. Zudem werden regelmäßig drei separate Antennen benötigt, um im Triangulationsverfahren die Position des RFID-Transponders bestimmen zu können.

Generell benötigen diese Systeme dabei grundsätzlich "Sichtkontakt" zwischen Sender und Empfänger, das heißt es wird eine sogenannte "Line of Sight" zwischen dem Satellit bzw. der Funkantenne einerseits und dem Empfänger in Form eines Receivers oder Transponders andererseits benötigt. In einer Baustellenumgebung ist dies selten möglich, sodass sich bisherige Erfassungssysteme nicht im großen Stil durchgesetzt haben.

Der vorliegenden Erfindung liegt hiervon ausgehend die Aufgabe zugrunde, eine verbesserte Vorrichtung der eingangs genannten Art zu schaffen, die Nachteile des Standes der Technik vermeidet und letzteren in vorteilhafter Weise weiterbildet. Insbesondere soll eine auch im Umfeld von Baustellen und den dort gegebenen Störeinflüssen verlässlich funktionierendes, kostengünstiges und robustes Erfassungssystem zum Bestimmen der Position und zum Identifizieren von Baumitteln auf der Baustelle geschaffen werden.

Erfindungsgemäß wird die genannte Aufgabe durch eine Vorrichtung gemäß Anspruch 1 gelöst. Bevorzugte Ausgestaltungen der Erfindung sind Gegenstand der abhängigen Ansprüche.

Es wird also vorgeschlagen, den Signalgeber mittels induktiver Kommunikation an die Auswerteeinrichtung anzubinden und über magnetische Strahlung bzw. Wellen zu orten. Erfindungsgemäß umfasst die Signalauswerteeinrichtung zumindest eine auf der Baustelle verlegte Schleifenantenne zum Empfangen des Identifikationssignals des Signalgebers und Bestimmen der Position des Signalgebers. Eine solche Schleifenantenne wird bisweilen auch als magnetische Loop-Antenne bezeichnet und ist dazu ausgelegt, auf die magnetische Komponente des elektromagnetischen Feldes bzw. des Identifikationssignals anzusprechen. Das Identifikationssignal, das von dem Signalgeber bereitgestellt wird, kann selbst im Wesentlichen magnetisch ausgebildet sein oder zumindest einen signifikanten magnetischen Anteil umfassen.

Durch solche Schleifenantennen, die auf ein magnetisches Identifikationssignal bzw. dessen magnetische Komponente ansprechen, können im Vergleich zu GPS- bzw. RFID-basierten Systemen beträchtliche Vorteile erzielt werden. Insbesondere treten auch bei massiven Metallkörper im Umfeld des Signalgebers beispielsweise in Form von Metallplatten, größeren Wasserflächen wie Baustellenpfützen oder Rohrleitungen, oder massiven Stahlbetondecken bzw. -wänden keine oder nur geringe Reflexionen oder Abschirmungen auf, sodass regelmäßig kein "Sichtkontakt" zwischen dem Signalgeber und der Schleifenantenne benötigt wird. Gleichzeitig ermöglicht die Verwendung einer Schleifenantenne eine Positionsbestimmung des Signalgebers, ohne dass drei oder mehr Schleifenantennen notwendig wären, wie dies beispielsweise bei herkömmlichen Triangulationsverfahren der Fall ist.

Reicht eine gröbere Positionierung auf der Baustelle oder ggfs. auch die bloße Kenntnis über die Anwesenheit eines Baumittels aus, kann eine einzige Schleifenantenne ausreichend sein, die beispielsweise entlang der äußeren Berandungen der Baustelle ausgelegt, insbesondere am oder im Boden verlegt sein kann. Hierbei ist immer noch eine gewisse Positionsbestimmung des Signalgebers innerhalb des von der Schleifenantenne umschlossenen Bereichs möglich, da eine Schleifenantenne die Richtung, aus der ein bestimmtes Signal kommt, und die Stärke des Signals in jedem Abschnitt der Schleifenantenne bestimmen kann. Vorteilhafterweise kann die mit der Schleifenantenne verbundene Signalauswerteeinrichtung dazu konfiguriert sein, aus der in verschiedenen Abschnitten der Schleifenantenne empfangenen Signalstärke und/oder Signalfrequenz die Position des Signalgebers relativ zur Schleifenantenne zu bestimmen.

Alternativ oder zusätzlich zu einer solchen, die ganze Baustelle oder zumindest einen signifikanten Teil der Baustelle umgebenden Schleifenantenne kann auch eine Schleifenantenne an der Einfahrt in die Baustelle angebracht werden, um Baumittel bei der Anlieferung zu erfassen. Eine solche Schleifenantenne an einer Baustellenzufahrt kann beispielsweise nach Art eines Torbogens in einer aufrechten Ebene angeordnet sein, sodass Lieferfahrzeuge durch die Schleifenantenne hindurchfahren können. Alternativ oder zusätzlich können auch Schleifenantennen lediglich seitlich an einer Begrenzung der Baustellenzufahrt und/oder im Bodenbereich der Baustellenzufahrt angeordnet werden, sodass die Identifikationssignale der Signalgeber, die an angelieferten Baumitteln angebracht sind, erfasst werden können, wenn das Lieferfahrzeug die Baustellenzufahrt passiert.

Vorteilhafterweise können mehrere Schleifenantennen vorgesehen sein, die in mehreren Sektoren der Baustelle angeordnet werden, sodass eine Unterteilung der Baustelle hinsichtlich der signaltechnischen Erfassung erreicht wird. Dabei ist es von Vorteil, dass sich auch relativ nahe nebeneinander ausgebrachte Schleifenantennen gegenseitig nicht beeinträchtigen, was die Erfassung verschiedener Identikationssignale verschiedener Signalgeber anbelangt. Insbesondere kann die Baustelle bzw. deren Grundfläche in eine Vielzahl von Sektoren unterteilt sein, denen jeweils eine Schleifenantenne zugeordnet wird, wobei die jeweilige Schleifenantenne beispielsweise entlang des jeweiligen Sektorenrandes ausgebracht, insbesondere im Boden oder auf dem Boden verlegt sein kann.

Um eine Erfassung von Bauteilen, die am Bauwerk verbaut werden, zu ermöglichen bzw. zu erleichtern, kann in vorteilhafter Weiterbildung der Erfindung auch zumindest eine Schleifenantenne am zu errichtenden Bauwerk verlegt sein. Vorteilhafterweise können am Bauwerk auch mehrere Schleifenantennen verlegt sein und verschiedenen Abschnitten des Bauwerks zugeordnet sein. Beispielsweise kann jedem Stockwerk eines Bauwerks eine eigene Schleifenantenne zugeordnet werden. Alternativ oder zusätzlich ist auch eine Ausbringung mehrerer Schleifenantennen auf demselben Stockwerk möglich, um verschiedene Stockwerksbereiche separat zu erfassen.

Wird beispielsweise eine Fertigbetontreppe oder ein Fassadenelement am Bauwerk verbaut, wird dies von der Schleifenantenne erfasst, indem die Position des Signalgebers in dem von der Schleifenantenne überwachten Bereich des Bauwerks erfasst wird. Hierdurch lässt sich eine Überwachung des Bauwerks und des Fortgangs der Bauarbeiten verlässlich realisieren, erfindungsgemäß sind auch von dem BIM gemachte Vorgaben zum Verbauen eines Bauteils überprüft werden.

Die zumindest eine Schleifenantenne kann grundsätzlich in verschiedenen Frequenzbereichen arbeiten und/oder Identifikationssignale verschiedener Wellenlängen erfassen. In vorteilhafter Weiterbildung der Erfindung kann die Schleifenantenne dazu ausgelegt sein, Langwellensignale in einem Wellenlängenbereich von 50 kHz bis 500 kHz, insbesondere etwa 100 kHz bis 250 kHz zu empfangen und/oder auszusenden, um mit dem Signalgeber zu kommunizieren.

Um Störungen durch überlagerte Fremdsignale zu reduzieren, kann die Schleifenantenne dabei dazu ausgebildet sein, nur ein relativ enges Wellenlängen- bzw. Frequenzfenster zu empfangen und/oder auszusenden, welches Wellenlängen- bzw. Frequenzfenster auf die Signalgeber und den davon abgegebenen Identifikationssignalen abgestimmt ist, das heißt die Signalfenster der Schleifenantenne werden so bestimmt, dass sie die Wellenlänge bzw. die Frequenz des Identifikationssignals der Signalgeber enthalten, dabei jedoch relativ eng begrenzt sind. Beispielsweise kann die Schleifenantenne dazu konfiguriert sein, nur ein oder mehrere Signalfenster zu empfangen und/oder abzusenden, die jeweils eine Fensterbreite von weniger als 50 kHz oder weniger als 25 kHz oder weniger als 10 kHz aufweisen.

Die verwendeten Signalgeber sind vorteilhafterweise dazu ausgelegt, ein magnetisches Identifikationssignal bzw. ein Identifikationssignal mit einem signifikanten Magnetfeldanteil auszusenden und/oder magnetisch zu arbeiten.

Insbesondere können die Signalgeber ein langwelliges Identifikationssignal im Bereich von 50 kHz bis 500 kHz, insbesondere 100 kHz bis 250 kHz abgeben.

Die Signalsender können hierbei unter Anwendung eines aktiven, drahtlosen Zwei-wege-Protokolls kurze Datenpakete von weniger als 512 Byte als Identifikationssignal abgeben.

Der Signalgeber kann dabei bidirektional und/oder on demand arbeitend ausgebildet sein, insbesondere in Form eines Transceivers, der Signale aktiv senden und Signale empfangen kann. Der Signalgeber kann hierbei einen Energiespeicher beispielsweise in Form einer Batterie oder eines Akkus umfassen, um Signale unabhängig vom vorherigen Empfang senden zu können. Alternativ wäre es aber auch möglich, aus empfangenen Signalen Energie zu gewinnen und/oder empfangene Signale in Antwortsignale zu wandeln, um dann ein Antwortsignal senden zu können.

Beispielsweise kann der Signalgeber nach dem IEEE 1902.1-Standard ausgebildet sein, beispielsweise in Form eines RuBee-Tags, vgl. Visible Assets Inc.: "Home", S. 1 bis 7, XP055539814.

Der Signalgeber ist vorteilhafterweise dazu konfiguriert, im Nahfeld mit der genannten Schleifenantenne bei einer Reichweite von bis zu 100m oder bis 75m oder bis zu 50m oder auch bis zu 25m zu kommunizieren. Durch Ausbildung als Nahfeld-Kommunikationsbaustein mit begrenzter Reichweite kann einerseits der Energiebedarf stark reduziert werden, während andererseits keine Störungen in Kommunikationsgeräten außerhalb der Baustelle induziert werden können.

Der Signalgeber ist vorteilhafterweise dazu konfiguriert, überwiegend magnetische Wellen als Signal abzugeben. Hierdurch können Störungen, die durch elektrische Felder impliziert werden, weitgehend vermieden werden.

Der Signalgeber kann vorteilhafterweise in Form eines kleinen Markierungsträgers oder eines Tags oder eines Labels ausgebildet sein, sodass der Signalgeber einfach am jeweiligen Baumittel anbringbar ist, beispielsweise angeklebt oder in anderer Weise befestigbar ist. Gegebenenfalls kann der Signalgeber auch in das jeweilige Baumittel eingegossen sein, beispielsweise in ein Fertigbetonteil. Da der Signalgeber magnetisch arbeitet, werden auch bei Einbettung in das Baumittelmaterial die vom Signalgeber gesendeten und/oder empfangenen Signale nicht behindert.

Der Signalgeber kann auch in Baumittel in Form von Schüttgut eingebettet werden, beispielsweise in einen Kies- oder Sandhaufen, der auf der Baustelle vorgehalten wird. Bei ausreichend unempfindlicher Ausbildung des Signalgebers kann dieser dabei auch Abladevorgänge mitmachen, beispielsweise wenn ein Sandhaufen in einem Lastwagen angeliefert und auf der Baustelle abgeladen wird.

Die durch die induktive Kommunikation zwischen Signalgeber und Schleifenantenne gewonnen Informationen bzw. Daten werden in verschiedener Weise genutzt, um die Baustelle zu überwachen und/oder zu steuern und/oder zu visualisieren. Insbesondere können die identifizierten und hinsichtlich ihrer Position bestimmten Baumittel zum Steuern der Baumaschinen verwendet werden, beispielsweise dahingehend, dass einem Kran oder einem Lader die Position eines jeweiligen Baumittels übermittelt wird, sodass der Kran oder Lader automatisiert den Aufnahmepunkt anfahren kann.

Erfindungsgemäß werden die Daten über die Baumittel und deren Position jedoch auch dazu verwendet, einen Fortschritt auf der Baustelle zu überwachen und/oder zu visualisieren. Hierzu werden die Identifikations- und Positionsdaten, die aus der Erfassung der Baumittel auf der Baustelle gewonnen wurden, in ein Daten- und Informationssystem eingespeist, das verschiedenen Nutzergruppen Zugang zu den Daten gewährt.

Vorteilhafterweise kann hierbei das genannte Daten- und Informationssystem dazu konfiguriert sein, verschiedenen Nutzern unterschiedlich konfigurierte Datengruppen bereitzustellen.

Beispielsweise kann für eine erste Nutzergruppe ein erster Datensatz konfiguriert werden, der im Wesentlichen alle auf der Baustelle erfassten Daten umfasst. Diese erste Datengruppe kann beispielsweise Baustellen-Informationsdaten umfassen, die angeben, welche Baumittel zu welchem Zeitpunkt wo auf der Baustelle sind. Ferner können dies Maschinendaten vorzugsweise in Form von Echtzeitdaten, die über die auf der Baustelle befindlichen Baumaschinen, deren Tätigkeit und/oder Position Auskunft geben, sein. Ferner können dies BIM-Daten sein, insbesondere dreidimensionale Bauwerksdaten sowie ergänzend hierzu Zeit- und/oder Kostendaten. Ferner können Bilddaten in Form visueller Kameradaten oder in Form bildgebender Sensordaten in den genannten Datensatz für die erste Nutzergruppe enthalten sein. Dieser erste Datensatz für die genannte erste Nutzergruppe kann insbesondere für Systemanbieter, Datenadministratoren bzw. die Konstrukteure der Baumaschinenhersteller bestimmt sein.

Das genannte Daten- und Informationssystem kann ferner eine zweite Datengruppe konfigurieren, die für eine andere, zweite Nutzergruppe bestimmt ist, wobei ein solcher zweiter Datensatz gegenüber dem erstgenannten Datensatz reduziert sein kann. Insbesondere können in den zweiten Datensatz die vorgenannten Baustellen-Informationsdaten, die genannten BIM-Daten und ggfs. die genannten Bilddaten enthalten sein. Ein solcher zweiter Datensatz kann Nutzern einer zweiten Nutzergruppe, beispielsweise den Zulieferern für die Baustoffe wie Sand, Kies usw. und die Baumaterialien wie Betonbauteile, Fassadenelemente und ähnliches sowie die Logistikunternehmen zum Anliefern und Umschlagen der Baumittel übermittelt und/oder abrufbar bereitstellen.

Ferner kann es sinnvoll sein, eine dritte Datengruppe für eine dritte Nutzergruppe zu konfigurieren und bereitzustellen. Die Daten dieser dritten Datengruppe können grundsätzlich den Daten der zweiten Datengruppe ähnlich sein, beispielsweise die Baustellen-Informationsdaten und die BIM-Daten umfassen, wobei die Bilddaten weggelassen oder auch inkludiert sein können. Eine solche dritte Nutzergruppe können beispielsweise Projektplaner, Architekten und Infrastrukturprojektierer sein.

Vorteilhafterweise wird insbesondere auch für eine vierte Nutzergruppe eine vierte Datengruppe von dem Daten- und Informationssystem konfiguriert, wobei eine solche vierte Datengruppe vorteilhafterweise abstrahierte und/oder verallgemeinerte und/oder weniger detailreiche Baustellen-Informationsdaten enthalten kann, beispielsweise Wetter-, Temperatur- und Baustellenstatusdaten. Ferner kann die vierte Datengruppe abstrahierte BIM-Daten umfassen, die zur Verwendung in Augmented Reality-Anwendungen auf Bildschirmen oder Augmented Reality-Brillen konfiguriert sind, insbesondere derart, dass sie von Augmented Reality-Applikationen visualisierbar sind. Solche abstrahierten BIM-Daten können insbesondere den aktuellen Status des Bauwerks umfassen, beispielsweise in welchem Stockwerk sich der Rohbau befindet und/oder ob bereits das Dach montiert ist und/oder ob bereits Fassadenelemente angebracht sind, sodass der vierten Nutzergruppe der aktuelle Status des Bauwerks visualisiert werden kann.

Vorteilhafterweise können zusätzlich zu den genannten abstrahierten Baustellen-Informationsdaten und/oder abstrahierten BIM-Daten auch Realdaten, insbesondere Bilddaten einer Kamera und/oder bildgebende Sensordaten in der vierten Datengruppe enthalten sein, die ebenfalls zur Verwendung in Augmented Reality-Anwendungen konfiguriert sein können. Hierdurch können bei Abruf der Daten aus der vierten Datengruppe von einem Nutzer der vierten Nutzergruppe Augmented Reality-Anwendungen oder Mixed Reality-Anwendungen dargestellt, das heißt auf einem Bildschirm oder einer Augmented Reality-Brille angezeigt werden.

Vorteilhafterweise können für eine fünfte Nutzergruppe weitere Daten in eine fünfte Datengruppe konfiguriert werden, die insbesondere die BIM-Daten enthalten können, also beispielsweise Material und 3D-Bauwerksdaten, die für den Abriss und die Entsorgung der verbauten Materialien relevant sind. Eine solche Datengruppe kann insbesondere für Abbruchunternehmen und Recyclingunternehmen bereitgestellt werden.

Die Erfindung wird nachfolgend anhand eines bevorzugten Ausführungsbeispiels und zugehöriger Zeichnungen näher erläutert. In den Zeichnungen zeigen:
Fig. 1: eine schematische Darstellung einer Baustelle, die in verschiedenen Sektoren mit verschiedenen Schleifenantennen zur Erfassung in den Sektoren befindlicher Baumittel versehen ist,
Fig. 2: eine schematische Darstellung der Anbindung der Baustelle aus Fig. 1 an ein Daten- und Informationssystem, in dem die gewonnenen Identifikations- und Positionsdaten der auf der Baustelle verwendeten Baumittel gespeichert, in verschiedene Datensätze konfiguriert und verschiedenen Datennutzern bereitgestellt werden, und
Fig. 3: eine schematische Darstellung der für verschiedene Nutzergruppen verschieden konfigurierten Datensätze des Daten- und Informationssystems aus Fig. 2.

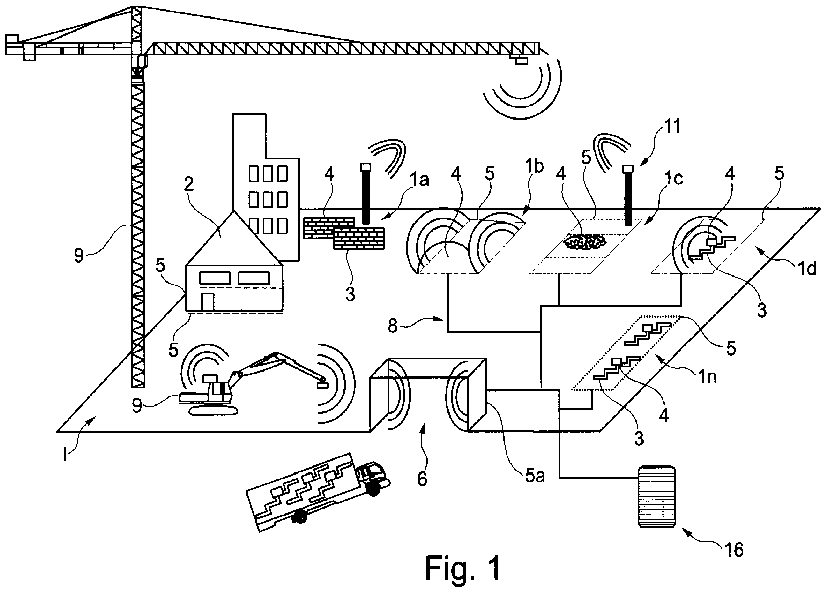

Wie Fig. 1 zeigt, kann eine Baustelle 1, auf der ein Bauwerk 2 beispielsweise in Form eines Gebäudes oder Hauses errichtet wird, in an sich bekannter Weise verschiedene Sektoren 1a, 1b, 1c ... 1n umfassen, in denen verschiedene Baumittel gelagert bzw. bereitgehalten oder am Bauwerk 2 verbaut werden oder auch vormontiert werden. Beispielsweise kann in einem ersten Baustellensektor 1a stapelbares Baumaterial beispielsweise in Form von Ziegelsteinen und/oder Fertigwandbauteilen bereitgehalten werden. Beispielsweise können auf Paletten gestapelte Ziegel oder Trockenbauwandteile dort gelagert werden.

In einem zweiten Baustellensektor 1b kann beispielsweise Schüttgut in Form von Sand gelagert werden.

In einem weiteren Baustellensektor 1c kann ebenfalls Schüttgut beispielsweise in Form von Kies oder ähnlichem Material gelagert werden.

In einem weiteren Baustellensektor können Fertigbetonbauteile wie beispielsweise eine Treppe bereitgehalten werden.

In einem weiteren Baustellensektor 1n können andere Bauelemente wie beispielsweise Fassadenelemente, aber auch Bauhilfselemente wie Schalungsteile oder Stützstreben oder Gerüstteile gelagert werden.

Jedem der genannten Baumittel 3 kann jeweils ein Signalgeber 4 zugeordnet sein, der ein das jeweilige Baumittel 3 identifzierendes Identifikationssignal aussendet. Der genannte Signalgeber 4 kann hierbei an dem jeweiligen Bauteil befestigt sein, wobei bei dem beschriebenen Schüttgut in den Baustellensektoren 1b und 1c der jeweilige Signalgeber 4 lose in dem Schüttgut eingebettet sein kann.

Die genannten Signalgeber 4 senden dabei jeweils ein individuell kodiertes, vorzugsweise kurzes Identifikationssignal, das jedes Baumittel individuell identifiziert.

Die Signalgeber 4 sind hierbei vorteilhafterweise magnetisch arbeitend ausgebildet und senden die genannten Identifikationssignale mit signifikantem Magnetfeldanteil im Nahfeld mit begrenzter Reichweite von beispielsweise weniger als 30m ab.

Die Signalgeber 4 sind vorteilhafterweise in der eingangs bereits beschriebenen Weise als Transceiver ausgebildet, insbesondere in Form eines sogenannten RuBee-Tags.

Um die magnetische Komponente der Identifikationssignale der Signalgeber 4 zu erfassen, können an der Baustelle 1 Schleifenantennen 5 vorgesehen sein, die auf die magnetische Komponente von Signalen ansprechen und auf den Wellenlängenbereich der Signalgeber 4 abgestimmt sind. Beispielsweise können die genannten Signalgeber 4 in einem Frequenzbereich von 100 bis 150 kHz senden, wobei die Schleifenantennen 5 vorteilhafterweise dazu ausgelegt sind, Signale in einem oder mehreren Wellenlängenfenstern relativ enger Fensterbreite zu verarbeiten. Beispielsweise können die Schleifenantennen 5 dazu ausgelegt sein, in einer Fensterbreite von etwa 10 kHz um die Frequenz der Signalgeber 4 herum auf Signale anzusprechen.

Wie Fig. 1 zeigt, kann dabei eine erste Schleifenantenne 5 einer Baustellenzufahrt 6 zugeordnet sein, um Baumittel 3 bzw. die diesen zugeordneten Signalgeber 4 bei der Anlieferung auf die Baustelle 1 zu erfassen. Fährt beispielsweise ein anliefernder Lkw mit Signalgebern 4 versehene Baumittel 3 durch die Baustellenzufahrt 6, kann die genannte Schleifenantenne 5 die Signale der Signalgeber 4 erfassen und die auf die Baustelle gebrachten Baumittel 3 identifizieren.

Der Baustellenzufahrt 6 können dabei auch mehrere Schleifenantennen 5 zugeordnet sein, beispielsweise jeweils seitlich rechts und links und/oder oberhalb und/oder unterhalb der Durchfahrt, um angelieferte Baumittel 3 verlässlich zu erfassen.

Alternativ oder zusätzlich zu einer solchen Schleifenantenne an an der Baustellenzufahrt 6 kann eine Schleifenantenne 5 an den Rändern bzw. Begrenzungen der Baustelle 1 verlegt sein, um im Wesentlichen den gesamten Baustellenbereich zu erfassen.

Alternativ oder zusätzlich kann jedem der genannten Baustellensektoren 1a bis 1n eine jeweiliege Schleifenantenne 5 zugeordnet sein, wobei die Schleifenantennen 5 insbesondere jeweils die Ränder des jeweiligen Baustellensektors einfassen können. Beispielsweise können die genannten Schleifenantennen 5 jeweils am Boden oder auch in dem Boden verlegt sein, vgl. Fig. 1.

Die genannten Schleifenantennen 5 sind dabei einerseits mit einem zentralen Daten- und Informationsserver 12 verbunden, ggf. über einen Baustellenleitrechner 16, um die detektierten Informationen an den genannten Server 12 zu übermitteln. Die genannten Informationen sind dabei einerseits die Identifkationscodes, die die einzelnen Baumittel 3 identifzieren. Zum anderen sind dies Positionsdaten, die die jeweilige Position des erfassten Baumittels 3 auf der Baustelle 1 angeben. Diese Positionsdaten können einerseits die Positionen der verschiedenen Schleifenantennen 5 in den verschiedenen Baustellensektoren sein, beispielsweise dergestalt, dass ein bestimmtes Baumittel 3 im Sektor 1b positioniert ist. Alternativ oder zusätzlich können die Positionsdaten aber auch weiter detailliert bzw. spezifiziert sein dahingehend, dass die Position eines Baumittels 3, genauer gesagt des damit verbundenen Signalgebers 4 relativ zu der jeweiligen Schleifenantenne 5 näher bestimmt wird. Wie eingangs erläutert, kann die Position eines Signalgebers 4 relativ zur Schleifenantenne 5 aus der Signalstärke in verschiedenen Abschnitten einer Schleifenantenne 5 näher bestimmt werden, beispielsweise dergestalt, dass ein Signalgeber 4 exakt im Zentrum des von der Schleifenantenne umschlossenen Raums angeordnet oder aus dem Zentrum heraus eine bestimmte Strecke zu einem bestimmten Schleifenantennenabschnitt hin positioniert ist. Dies kann eine mit den Schleifenantennen 5 jeweils verbundene Signalauswerteeinrichtung 8 bestimmen.

Zum anderen können die Signalgeber 4 auch untereinander im Sinne eines Peer-to-peer-Systems kommunzieren. Hierzu kann beispielsweise auch an einer der Baumaschinen 9, beispielsweise dem dargestellten Kran und/oder dem dargestellten Bagger, ein entsprechender Signalgeber 4 und/oder eine Schleifenantenne 5 angebracht sein, insbesondere ein RuBee-Tag wie zuvor erläutert oder ein ähnlicher Transceiver, der mit einem anderen Transceiver bzw. Signalgeber direkt kommunizieren kann.

Eine solche direkte Kommunikation kann beispielsweise beinhalten, dass nach Erfassung eines bestimmten Baumittels 3 in einem bestimmten Baustellensektor 1c ein an der Baumaschine 9, beispielsweise dem Kran angebrachte Signalgeber 4 direkt mit dem Signalgeber 4 eines bestimmten Baumittels kommuniziert, wenn der Baumaschine 9 beispielsweise von einem Leitrechner mitgeteilt wurde, dass ein Baumittel eines bestimmten Typs im nächsten Schritt aufzunehmen ist, sodass die Baumaschine sozusagen abfragt, wo exakt sich ein Baumittel 3 mit dem entsprechenden Identifkationscode befindet.

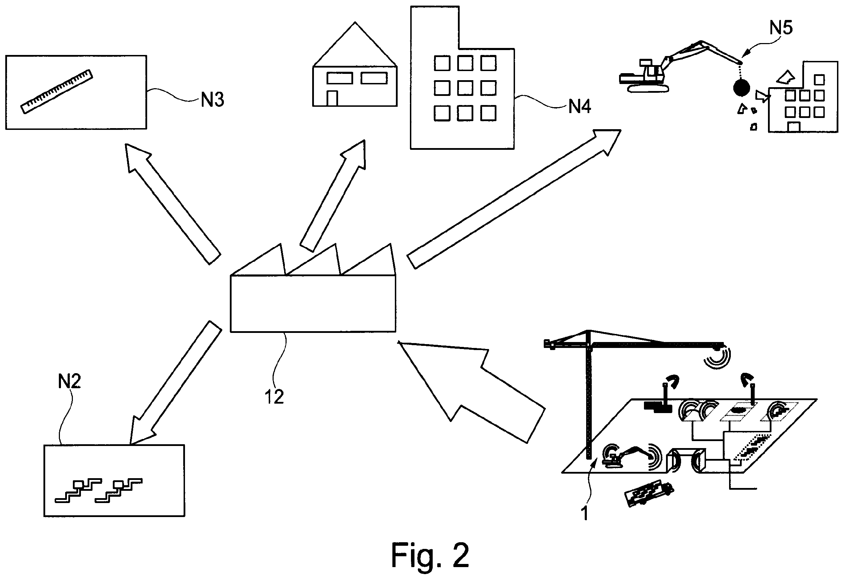

Wie Fig. 2 zeigt, können die in dem zentralen Daten- und Informationssystem 12 abgelegten Identifikations- und Positionsdaten auch verschiedenen Nutzergruppen zur Verfügung gestellt werden, beispielsweise durch aktives Weiterleiten im Sinne einer Push-Funktion oder abrufbar bereitstellen für eine Pull-Funktion der jeweiligen Nutzergruppe.

Vorteilhafterweise können dabei von dem Daten- und Informatiosserver 12 verschiedene Datensätze konfiguriert und/oder die Zugriffsrechte für verschiedene Nutzergruppen unterschiedlich konfiguriert werden.

Insbesondere können die Daten über die Baumittel und deren Position dazu verwendet werden, einen Fortschritt auf der Baustelle 1 zu überwachen und/oder zu visualisieren. Hierzu können die Identifikations- und Positionsdaten, die aus der Erfassung der Baumittel 3 auf der Baustelle 1 gewonnen wurden, in das Daten- und Informationssystem 12 eingespeist werden.

Beispielsweise kann für eine erste Nutzergruppe ein erster Datensatz konfiguriert werden, der im Wesentlichen alle auf der Baustelle 1 erfassten Daten umfasst. Diese erste Datengruppe kann beispielsweise Baustellen-Informationsdaten umfassen, die angeben, welche Baumittel 3 zu welchem Zeitpunkt wo auf der Baustelle 1 sind.

Ferner können dies Maschinendaten vorzugsweise in Form von Echtzeitdaten, die über die auf der Baustelle befindlichen Baumaschinen, deren Tätigkeit und/oder Position Auskunft geben, sein. Ferner können dies BIM-Daten sein, insbesondere dreidimensionale Bauwerksdaten sowie ergänzend hierzu Zeit- und/oder Kostendaten. Ferner können Bilddaten in Form visueller Kameradaten oder in Form bildgebender Sensordaten in den genannten Datensatz für die erste Nutzergruppe enthalten sein. Dieser erste Datensatz für die genannte erste Nutzergruppe kann insbesondere für Systemanbieter, Datenadministratoren bzw. die Konstrukteure der Baumaschinenhersteller bestimmt sein.

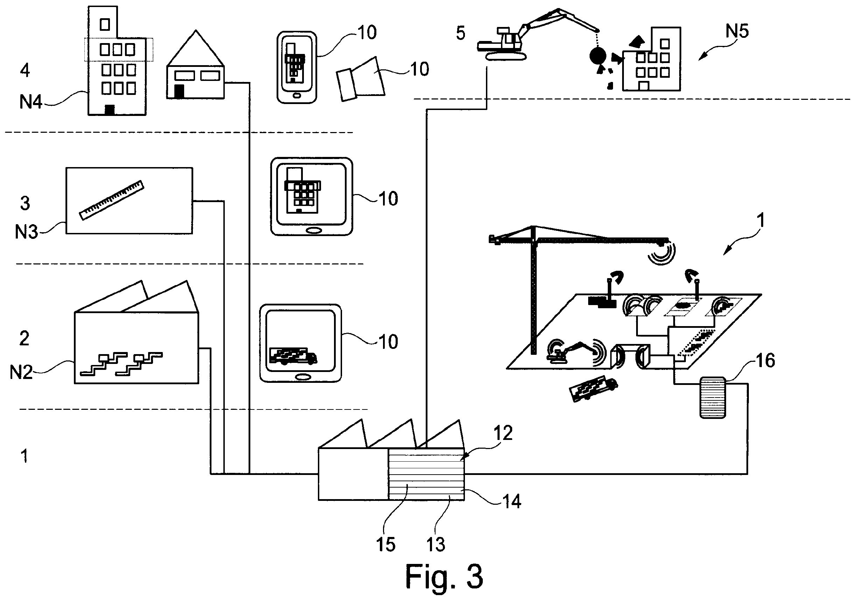

Das genannte Daten- und Informationssystem 12 kann ferner eine zweite Datengruppe konfigurieren, die für eine andere, zweite Nutzergruppe N2 bestimmt ist, wobei ein solcher zweiter Datensatz gegenüber dem erstgenannten Datensatz reduziert sein kann. Insbesondere können in den zweiten Datensatz die vorgenannten Baustellen-Informationsdaten, die genannten BIM-Daten und ggfs. die genannten Bilddaten enthalten sein. Ein solcher zweiter Datensatz kann Nutzern der zweiten Nutzergruppe N2, beispielsweise den Zulieferern für die Baustoffe 3 wie Sand, Kies usw. und die Baumaterialien wie Betonbauteile, Fassadenelemente und ähnliches sowie die Logistikunternehmen zum Anliefern und Umschlagen der Baumittel übermittelt und/oder abrufbar bereitstellen, vgl. Fig. 2 und 3.

Ferner kann es sinnvoll sein, eine dritte Datengruppe für eine dritte Nutzergruppe N3 zu konfigurieren und bereitzustellen. Die Daten dieser dritten Datengruppe können grundsätzlich den Daten der zweiten Datengruppe ähnlich sein, beispielsweise die Baustellen-Informationsdaten und die BIM-Daten umfassen, wobei die Bilddaten weggelassen oder auch inkludiert sein können. Eine solche dritte Nutzergruppe können beispielsweise Projektplaner, Architekten und Infrastrukturprojektierer sein.

Vorteilhafterweise wird insbesondere auch für eine vierte Nutzergruppe N4 eine vierte Datengruppe von dem Daten- und Informationssystem konfiguriert, wobei eine solche vierte Datengruppe vorteilhafterweise abstrahierte und/oder verallgemeinerte und/oder weniger detailreiche Baustellen-Informationsdaten enthalten kann, beispielsweise Wetter-, Temperatur- und Baustellenstatusdaten. Ferner kann die vierte Datengruppe N4 abstrahierte BIM-Daten umfassen, die zur Verwendung in Augmented Reality-Anwendungen auf Bildschirmen 10 oder Augmented Reality-Brillen konfiguriert sind, insbesondere derart, dass sie von Augmented Reality-Applikationen visualisierbar sind. Solche abstrahierten BIM-Daten können insbesondere den aktuellen Status des Bauwerks umfassen, beispielsweise in welchem Stockwerk sich der Rohbau befindet und/oder ob bereits das Dach montiert ist und/oder ob bereits Fassadenelemente angebracht sind, sodass der vierten Nutzergruppe N4 der aktuelle Status des Bauwerks visualisiert werden kann, vgl. Fig. 3.

Vorteilhafterweise können zusätzlich zu den genannten abstrahierten Baustellen-Informationsdaten und/oder abstrahierten BIM-Daten auch Realdaten, insbesondere Bilddaten einer Kamera und/oder bildgebende Sensordaten in der vierten Datengruppe enthalten sein, die ebenfalls zur Verwendung in Augmented Reality-Anwendungen konfiguriert sein können. Hierdurch können bei Abruf der Daten aus der vierten Datengruppe von einem Nutzer der vierten Nutzergruppe N4 Augmented Reality-Anwendungen oder Mixed Reality-Anwendungen dargestellt, das heißt auf einem Bildschirm 10 oder einer Augmented Reality-Brille angezeigt werden, vgl. Fig. 3.

Vorteilhafterweise können für eine fünfte Nutzergruppe N5 weitere Daten in eine fünfte Datengruppe konfiguriert werden, die insbesondere die BIM-Daten enthalten können, also beispielsweise Material und 3D-Bauwerksdaten, die für den Abriss und die Entsorgung der verbauten Materialien relevant sind. Eine solche Datengruppe kann insbesondere für Abbruchunternehmen und Recyclingunternehmen bereitgestellt werden, vgl. Fig. 2 und 3.

Insbesondere kann von dem Daten- und/oder Informationsserver 12 ein Abgleich zwischen Planungs- und/oder Logistikdaten, die in dem BIM abgelegt sind, und den über die Schleifenantenne 5 und die Signalgeber 4 erfassten und von der Signalauswerteeinrichtung 8 ausgewerteten Daten vorgenommen werden, um den Baufortgang zu überwachen, insbesondere ob im BIM abgelegte Bauschritte auch tatsächlich schon ausgeführt worden sind. Hierzu können insbesondere die Informationen nützlich sein, ob ein bestimmtes Baumittel 3 bereits im Bauwerk 3 verbaut worden ist. Beispielsweise kann dies die Information sein, ob eine bestimmte Fertigbetontreppe oder ein bestimmtes Fassadenelement schon am Bauwerk 2 verbaut und dementsprechend von der dem Bauwerk 2 zugeordneten Schleifenantenne erfasst worden ist.

Die in dem Daten- und Informationsserver 12 bereitgehaltenen Daten können auch für die Visualisierung der Baustelle 1 und/oder des Bauwerks 2 konfiguriert werden, um auf einer Anzeigevorrichtung 10 einer jeweiligen Nutzergruppe angezeigt zu werden. Dies kann, wie eingangs schon erläutert, ein normaler Bildschirm auf einem PC oder der Bildschirm 10 eines Mobilgeräts wie eines Tablets oder auch eine Augmented Reality-Brille sein. Vorteilhafterweise konfiguriert der Daten- und Informationsserver 12 und/oder ein damit verbundener Konfigurationsbaustein die für die Visualisierung vorgesehenen Daten derart, dass eine aus dem jeweiligen Endgerät installierte Visualisierungssoftware die Baustelle 1 darstellen kann und dabei die bestimmten Informationen über die Anwesenheit und/oder Position und/oder den Verbauungszustand der Baumittel 3 berücksichtigt.

## Patentansprüche

1. Vorrichtung zum Steuern und/oder Überwachen und/oder Visualisieren von Baustellen (1), mit einer Erfassungseinrichtung (11) zum Erfassen der Position eines Baumittels (3) auf der Baustelle (1), wobei die Erfassungseinrichtung (11) einen am Baumittel (3) anbringbaren Signalgeber (4) zum Bereitstellen einen das Baumittel identifizierenden Identifikationssignals sowie eine Signalauswerteeinrichtung (8) zum Empfangen und Auswerten des Identifikationssignals zum Bestimmen der Position des Baumittels (3) auf der Baustelle (1) aufweist, wobei die Signalauswerteeinrichtung (8) mit einer zentralen Informationseinheit (12) verbindbar ist, in welcher Informationseinheit (12) anhand der übermittelten Identifikations- und Positionsdaten Baumitteldaten, die die Position der auf der Baustelle (1) befindlichen Baumittel (3) angeben, speicherbar sind,
**dadurch gekennzeichnet, dass** die Signalauswerteeinrichtung (8) zumindest eine auf der Baustelle (1) verlegte Schleifenantenne (5) zum Empfangen des Identifikationssignals und Bestimmen der Position des Signalgebers (4) aufweist,
wobei die Informationseinheit (12) ein Überwachungsmodul (16) zum Überwachen eines Baufortschritts anhand der gespeicherten Baumitteldaten (3) aufweist, wobei das genannte Überwachungsmodul (16) dazu konfiguriert ist, Planungsdaten aus einem BIM mit Identifikations- und Positionsdaten eines Baumittels (3) abzugleichen und aus dem Abgleich zu bestimmen, ob ein in den Planungsdaten des BIM enthaltener Bauschritt ausgeführt ist oder nicht.

2. Vorrichtung nach dem vorhergehenden Anspruch, wobei die Signalauswerteeinrichtung (8) eine Vielzahl von Schleifenantennen (5) umfasst, die in verschiedenen Baustellensektoren (1a, 1b, 1c, 1n), in die die Baustelle (1) unterteilt ist, verlegt sind und dazu konfiguriert sind, nur auf Signalgeber (4) anzusprechen, die sich in dem jeweiligen Baustellensektor, in dem die jeweilige Schleifenantenne verlegt ist, befinden.

3. Vorrichtung nach einem der vorhergehenden Ansprüche, wobei die Signalauswerteeinrichtung (8) zumindest eine Schleifenantenne (5) umfasst, die an der Baustellenzufahrt (6) angeordnet und zum Erfassen der Identifikationssignale von Signalgebern (4), die durch die Baustellenzufahrt (6) transportiert werden, konfiguriert ist.

4. Vorrichtung nach einem der vorhergehenden Ansprüche, wobei die Signalerfassungseinrichtung (8) zumindest eine Schleifenantenne (5) umfasst, die an einem zu errichtenden Bauwerk (2) auf der Baustelle (1) verlegt ist und zum Erfassen eines Signalgebers, der an einem an dem Bauwerk (2) zu verbauenden Baumittel angebracht ist, konfiguriert ist.

5. Vorrichtung nach dem vorhergehenden Anspruch, wobei mehrere Schleifenantennen (5) verschiedenen Bauwerksabschnitten, insbesondere verschiedenen Bauwerksstockwerken, zugeordnet sind und dazu konfiguriert sind, nur auf Signale von Signalgebern (4) anzusprechen, die in dem jeweiligen Bauwerksabschnitt, in dem die jeweilige Schleifenantenne (5) angeordnet ist, anzusprechen.

6. Vorrichtung nach einem der vorhergehenden Ansprüche, wobei die zumindest eine Schleifenantenne (5) dazu ausgelegt ist, nur auf die magnetische Komponente eines elektromagnetischen Signals anzusprechen und der an dem Baumittel (3) anbringbare Signalgeber (4) magnetisch arbeitend ausgebildet ist und Identifikationssignale bereitstellt, die zumindest einen signifikanten magnetischen Wellenanteil aufweisen.

7. Vorrichtung nach einem der vorhergehenden Ansprüche, wobei die zumindest eine Schleifenantenne (5) dazu ausgelegt, auf langwellige Signale in einem Wellenlängenbereich von 50 kHz bis 500 kHz, insbesondere 100 kHz bis 250 kHz und nur auf Signale in einem engen Wellenlängenfenster mit einer Fensterbreite von weniger als 50 kHz oder weniger als 25 kHz anzusprechen, wobei der Signalgeber (4) dazu ausgebildet ist, langwellige Identifikationssignale in einem Wellenlängebereich zwischen 50 kHz und 500 kHz, insbesondere 100 kHz bis 250 kHz, abzugeben.

8. Vorrichtung nach einem der vorhergehenden Ansprüche, wobei der Signalgeber (4) dazu ausgebildet ist, kurze Datenpakete von weniger als 512 Byte unter einem aktiven, drahtlosen Zwei-Wege-Protokoll und/oder Verwendung einer Internetprotokoll-Adresse zu versenden.

9. Vorrichtung nach einem der vorhergehenden Ansprüche, wobei der Signalgeber (4) als induktiver Nahfeld-Kommunikationsbaustein mit einer Signalreichweite von weniger als 100m oder weniger als 50m oder weniger als 25m ausgebildet ist.

10. Vorrichtung nach einem der vorhergehenden Ansprüche, wobei der Signalgeber (4) als Transceiver ausgebildet ist und/oder einen Energiespeicher zum aktiven Erzeugen von Signalen aufweist und/oder einen Mikroprozessor mit einem zugeordneten Speicherbaustein besitzt und/oder zumindest einen Sensor aus der Gruppe Temperatursensor, Feuchtesensor, Beschleunigungssensor, Helligkeitssensor und Drucksensor aufweist.

11. Vorrichtung nach einem der vorhergehenden Ansprüche, wobei die Signalauswerteeinrichtung (8) Positionsbestimmungsmittel zum Bestimmen der Position eines Signalgebers (4) relativ zu der Schleifenantenne (5) anhand der in verschiedenen Schleifenantennenabschnitten induzierten Signalstärke aufweist.

12. Vorrichtung nach einem der vorhergehenden Ansprüche, wobei eine Vielzahl an Signalgebern (4) vorgesehen sind, die verschiedenen Baumitteln (3) zugeordnet sind, wobei die Signalgeber (4) dazu ausgebildet sind, direkt miteinander nach Art eines Peer-to-peer-Systems zu kommunizieren.

13. Vorrichtung nach einem der vorhergehenden Ansprüche, wobei die Baumittel (3) an einem Bauwerk (2) zu verbauende Baustoffe wie Sand, Kies oder Armierungselemente und/oder Baumaterialien wie Fassadenelemente, Betonbauteile, Fertigwandteile oder Bauwerkversorgungsbaugruppen, und/oder Bauhilfsmittel wie Schalungselemente, Abstützstreben oder Gerüstteile umfassen, an denen jeweils ein Signalgeber (4) angebracht ist.

14. Vorrichtung nach einem der vorhergehenden Ansprüche, wobei die Informationseinheit (12) Kommunikationsmittel zum Übermitteln und/oder abrufbaren Bereitstellen der Baumitteldaten und/oder weiterer Baustellendaten an verschiedene Nutzer aufweist, wobei die Informationseinheit (12) ein Datenkonfigurationsmodul (13) zum Konfigurieren verschie-dener Datensätze für verschiedene Nutzer in Abhängigkeit der gespeicherten Baumitteldaten aufweist.

15. Vorrichtung nach einem der vorhergehenden Ansprüche, wobei die Informationseinheit (12) ein Visualisierungs-Konfiguratormodul (14) zum Konfigurieren von Visualisierungsdaten, die auf einer Anzeigeeinrichtung (10) eines Nutzers anzeigbar sind, in Abhängigkeit der übermittelten Baumittel-Identifikations- und -Positionsdaten aufweist, wobei das Visualisierungs-Konfiguratormodul (14) dazu ausgebildet ist, Bilddaten in Abhängigkeit der von der zumindest einen Schleifenantenne (5) erfassten Identifikationssignale und der daraus bestimmten Positionsdaten eines Baumittels (3) zu erzeugen, welche Bilddaten ein jeweils aktualisiertes Bild der Baustelle (1) und/oder eines darauf zu errichtenden Bauwerks (2) definieren.

## Claims

1. A device for controlling and/or monitoring and/or visualizing construction sites (1), comprising a detection device (11) for detecting the position of a construction means (3) at the construction site (1), wherein the detection device (11) includes a signal transmitter (4) to be mounted on the construction means (3) in order to provide an identification signal identifying the construction means, and a signal evaluation device (8) for receiving and evaluating the identification signal in order to determine the position of the construction means (3) at the construction site (1), wherein the signal evaluation device (8) can be connected to a central information unit (12), in which information unit (12) construction means data indicating the position of the construction means (3) located on the construction site (1) can be stored with reference to the transmitted identification and position data,
**characterized in that** the signal evaluation device (8) includes at least one loop antenna (5) laid on the construction site (1) for receiving the identification signal and determining the position of the signal transmitter (4), wherein the information unit (12) includes a monitoring module (16) for monitoring a construction progress with reference to the stored construction means data (3), wherein said monitoring module (16) is configured to compare planning data from a BIM with identification and position data of a construction means (3) and to determine from the comparison whether or not a construction step contained in the planning data of the BIM is carried out.

2. The device according to the preceding claim, wherein the signal evaluation device (8) comprises a plurality of loop antennas (5) which are laid in different construction site sectors (1a, 1b, 1c, 1n), into which the construction site (1) is divided, and are configured to respond only to signal transmitters (4) that are located in the respective construction site sector in which the respective loop antenna is laid.

3. The device according to any of the preceding claims, wherein the signal evaluation device (8) comprises at least one loop antenna (5) which is arranged at the site entrance (6) and configured for detecting the identification signals of signal transmitters (4) which are transported through the construction site entrance (6).

4. The device according to any of the preceding claims, wherein the signal detection device (8) comprises at least one loop antenna (5) which is laid on a building (2) to be erected on the construction site (1) and is configured to detect a signal transmitter which is mounted on a construction means to be installed at the building (2).

5. The device according to the preceding claim, wherein a plurality of loop antennas (5) are associated to different building portions, in particular different building floors, and are configured to respond only to signals from signal transmitters (4) which are arranged in the respective building portion in which the respective loop antenna (5) is arranged.

6. The device according to any of the preceding claims, wherein the at least one loop antenna (5) is designed to respond only to the magnetic component of an electromagnetic signal and the signal transmitter (4) to be mounted on the construction means (3) is configured to operate magnetically and provides identification signals which at least include a significant magnetic wave fraction.

7. The device according to any of the preceding claims, wherein the at least one loop antenna (5) is designed to respond to long-wave signals in a wavelength range of 50 kHz to 500 kHz, in particular 100 kHz to 250 kHz, and only to signals in a narrow wavelength window with a window width of less than 50 kHz or less than 25 kHz, wherein the signal transmitter (4) is configured to output long-wave identification signals in a wavelength range between 50 kHz and 500 kHz, in particular 100 kHz to 250 kHz.

8. The device according to any of the preceding claims, wherein the signal transmitter (4) is configured to send short data packets of less than 512 Byte under an active, wireless two-way protocol and/or by using an Internet protocol address.

9. The device according to any of the preceding claims, wherein the signal transmitter (4) is configured as an inductive near-field communication module with a signal range of less than 100m or less than 50m or less than 25m.

10. The device according to any of the preceding claims, wherein the signal transmitter (4) is configured as a transceiver and/or includes an energy accumulator for actively generating signals and/or has a microprocessor with an associated memory module and/or has at least one sensor from the group including a temperature sensor, humidity sensor, acceleration sensor, brightness sensor and pressure sensor.

11. The device according to any of the preceding claims, wherein the signal evaluation device (8) comprises position determining means for determining the position of a signal transmitter (4) relative to the loop antenna (5) with reference to the signal strength induced in different loop antenna portions.

12. The device according to any of the preceding claims, wherein a plurality of signal transmitters (4) are provided, which are associated to different construction means (3), wherein the signal transmitters (4) are configured to directly communicate with each other in the manner of a peer-to-peer system.

13. The device according to any of the preceding claims, wherein the construction means (3) comprise building materials to be installed at a building, such as sand, gravel or armoring elements, and/or construction materials such as facade elements, concrete components, prefabricated wall parts or building supply assemblies, and/or construction aids such as formwork elements, supporting struts or scaffolding parts, on each of which a signal transmitter (4) is mounted.

14. The device according to any of the preceding claims, wherein the information unit (12) comprises communication means for transmitting and/or retrievably providing the construction means data and/or further construction site data to different users, wherein the information unit (12) includes a data configuration module (13) for configuring different data sets for different users in dependence on the stored construction means data.

15. The device according to any of the preceding claims, wherein the information unit (12) comprises a visualization configurator module (14) for configuring visualization data which can be displayed on a display device (10) of a user in dependence on the transmitted construction means identification and position data, wherein the visualization configurator module (14) is configured to generate image data in dependence on the identification signals detected by the at least one loop antenna (5) and the position data of a construction means (3) determined therefrom, which image data define a respectively updated image of the construction site (1) and/or of a building (2) to be erected thereon.

## Revendications

1. Dispositif pour commander et/ou surveiller et/ou visualiser des chantiers (1), comprenant un dispositif de détection (11) pour détecter la position d'un moyen de construction (3) sur le chantier (1), le dispositif de détection (11) présentant un transmetteur de signaux (4) pouvant être monté sur le moyen de construction (3) pour fournir un signal d'identification identifiant le moyen de construction ainsi qu'un dispositif d'évaluation de signaux (8) pour recevoir et évaluer le signal d'identification afin de déterminer la position du moyen de construction (3) sur le chantier (1), le dispositif d'évaluation de signaux (8) pouvant être relié à une unité d'information centrale (12), unité d'information (12) dans laquelle peuvent être stockées, à l'aide des données d'identification et de position transmises, des données de moyens de construction qui indiquent la position des moyens de construction (3) se trouvant sur le chantier (1),
**caractérisé en ce que** le dispositif d'évaluation de signaux (8) comprend au moins une antenne en boucle (5) installée sur le chantier (1) pour recevoir le signal d'identification et déterminer la position du transmetteur de signaux (4), l'unité d'information (12) comprenant un module de surveillance (16) pour surveiller une progression de la construction à l'aide des données du moyen de construction (3) stockées, ledit module de surveillance (16) étant configuré pour comparer des données de planification provenant d'un BIM avec des données d'identification et de position d'un moyen de construction (3) et pour déterminer, à partir de la comparaison, si une étape de construction contenue dans les données de planification du BIM est exécutée ou non.

2. Dispositif selon la revendication précédente, dans lequel le dispositif d'évaluation de signaux (8) comprend une pluralité d'antennes en boucle (5) posées dans différents secteurs de chantier (1a, 1b, 1c, 1n), dans lesquels le chantier (1) est divisé, et configurées pour répondre uniquement à des transmetteurs de signaux (4) situés dans le secteur de chantier respectif dans lequel l'antenne en boucle respective est posée.

3. Dispositif selon l'une quelconque des revendications précédentes, dans lequel le dispositif d'évaluation de signaux (8) comprend au moins une antenne en boucle (5) agencée sur l'accès au chantier (6) et configurée pour détecter les signaux d'identification de transmetteurs de signaux (4) transportés à travers l'accès au chantier (6).

4. Dispositif selon l'une quelconque des revendications précédentes, dans lequel le dispositif de détection de signaux (8) comprend au moins une antenne en boucle (5) posée sur un bâtiment (2) à construire sur le chantier (1) et configurée pour détecter un transmetteur de signaux monté sur un moyen de construction à installer sur le bâtiment (2).

5. Dispositif selon la revendication précédente, dans lequel plusieurs antennes en boucle (5) sont associées à différentes sections de bâtiment, en particulier à différents étages du bâtiment, et sont configurées pour ne répondre qu'à des signaux provenant de transmetteurs de signaux (4) qui répondent dans la section de bâtiment respective dans laquelle est agencée l'antenne en boucle (5) respective.

6. Dispositif selon l'une quelconque des revendications précédentes, dans lequel ladite au moins une antenne en boucle (5) est conçue pour répondre uniquement à la composante magnétique d'un signal électromagnétique, et le transmetteur de signaux (4) pouvant être monté sur le moyen de construction (3) est conçu pour fonctionner magnétiquement et fournit des signaux d'identification qui comprennent au moins une composante d'onde magnétique significative.

7. Dispositif selon l'une quelconque des revendications précédentes, dans lequel ladite au moins une antenne en boucle (5) est conçue pour répondre à des signaux de grande longueur d'onde dans une plage de longueurs d'onde de 50 kHz à 500 kHz, en particulier de 100 kHz à 250 kHz, et uniquement à des signaux dans une fenêtre de longueurs d'onde étroite ayant une largeur de fenêtre inférieure à 50 kHz ou inférieure à 25 kHz, le transmetteur de signaux (4) étant conçu pour émettre des signaux d'identification de grande longueur d'onde dans une plage de longueurs d'onde comprise entre 50 kHz et 500 kHz, en particulier de 100 kHz à 250 kHz.

8. Dispositif selon l'une quelconque des revendications précédentes, dans lequel le transmetteur de signaux (4) est conçu pour envoyer de courts paquets de données de moins de 512 octets sous un protocole bidirectionnel actif sans fil et/ou en utilisant une adresse de protocole Internet.

9. Dispositif selon l'une quelconque des revendications précédentes, dans lequel le transmetteur de signaux (4) est conçu comme un module de communication inductif en champ proche avec une portée de signal inférieure à 100m ou inférieure à 50m ou inférieure à 25m.

10. Dispositif selon l'une quelconque des revendications précédentes, dans lequel le transmetteur de signaux (4) est conçu comme un émetteur-récepteur et/ou présente un accumulateur d'énergie pour la génération active de signaux et/ou possède un microprocesseur avec un module de mémoire associé et/ou présente au moins un capteur du groupe capteur de température, capteur d'humidité, capteur d'accélération, capteur de luminosité et capteur de pression.

11. Dispositif selon l'une quelconque des revendications précédentes, dans lequel le dispositif d'évaluation de signaux (8) comprend des moyens de détermination de position pour déterminer la position d'un transmetteur de signaux (4) par rapport à l'antenne en boucle (5) à partir de l'intensité du signal induit dans différentes sections d'antenne en boucle.

12. Dispositif selon l'une quelconque des revendications précédentes, dans lequel il est prévu une pluralité de transmetteurs de signaux (4) associés à différents moyens de construction (3), les transmetteurs de signaux (4) étant conçus pour communiquer directement entre eux à la manière d'un système d'égal à égal.

13. Dispositif selon l'une quelconque des revendications précédentes, dans lequel les moyens de construction (3) comprennent des matériaux de construction à mettre en place sur un bâtiment (2), tels que du sable, du gravier ou des éléments d'armature, et/ou des matériaux de construction tels que des éléments de façade, des éléments de construction en béton, des éléments de paroi préfabriqués ou des ensembles d'alimentation du bâtiment, et/ou des moyens auxiliaires de construction tels que des éléments de coffrage, des entretoises ou des éléments d'échafaudage, sur chacun desquels est monté un transmetteur de signaux (4).

14. Dispositif selon l'une quelconque des revendications précédentes, dans lequel l'unité d'information (12) présente des moyens de communication pour transmettre et/ou mettre à disposition de manière interrogeable les données de moyens de construction et/ou d'autres données de chantier à différents utilisateurs, dans lequel l'unité d'information (12) présente un module de configuration de données (13) pour configurer différents ensembles de données pour différents utilisateurs en dépendance des données de moyens de construction stockées.

15. Dispositif selon l'une quelconque des revendications précédentes, dans lequel l'unité d'information (12) comprend un module configurateur de visualisation (14) pour configurer des données de visualisation pouvant être affichées sur un dispositif d'affichage (10) d'un utilisateur, en dépendance des données d'identification et de position du moyen de construction transmises, le module configurateur de visualisation (14) étant conçu pour générer des données d'image en dépendance des signaux d'identification détectés par l'au moins une antenne en boucle (5) et des données de position d'un moyen de construction (3) déterminées à partir de ceux-ci, lesquelles données d'image définissent une image respectivement actualisée du chantier (1) et/ou d'un bâtiment (2) à construire sur celui-ci.
